# FASCICULE DE BREVET EUROPEEN

(11) **EP 3 168 885 B1**
(45) Date de publication et mention de la délivrance du brevet: **01.08.2018**
(21) Numéro de dépôt: 16197921.6
(22) Date de dépôt: 09.11.2016
(51) Int. Cl.: H01L 45/00

(54) **PROCÉDÉ DE FABRICATION D'UNE MÉMOIRE PCRAM**
HERSTELLUNGSVERFAHREN EINES PCRAM-SPEICHERS
METHOD FOR MANUFACTURING A PCRAM MEMORY

(30) Priorité: 13.11.2015 FR 1560903
(43) Date de publication de la demande: 17.05.2017
(73) Titulaire: COMMISSARIAT À L'ÉNERGIE ATOMIQUE ET AUX ÉNERGIES ALTERNATIVES, 75015 Paris (FR)
(72) Inventeur: NAVARRO, Gabriele, 38000 Grenoble (FR)
(74) Mandataire: Cabinet Camus Lebkiri

(56) Documents cités:
- US-A1- 2007 152 205
- US-A1- 2010 190 321

## Description

### DOMAINE TECHNIQUE

La présente invention est relative à un procédé de fabrication d'une mémoire vive à changement de phase, plus connue sous la dénomination anglaise de « PCRAM » pour « Phase-Change Random Access Memory ».

### ETAT DE LA TECHNIQUE

Dans une mémoire PCRAM, chaque bit d'information est stocké dans une cellule ou point mémoire comprenant un matériau à changement de phase, typiquement un matériau chalcogénure (ex. GeTe, Ge₂Sb₂Te₅), disposé entre une électrode inférieure et une électrode supérieure. Un matériau à changement de phase est capable de basculer très rapidement et de façon réversible entre une phase amorphe et une phase cristalline. Or ces deux phases présentent de grandes différences de propriétés. La phase amorphe est notamment caractérisée par une résistivité électrique élevée, tandis que la phase cristalline présente une résistivité électrique beaucoup plus faible.

Ainsi, le bit d'information est codé par la différence de résistivité entre l'état amorphe et l'état cristallin du matériau à changement de phase. Typiquement, l'état amorphe représente le niveau logique '0' et l'état cristallin représente le niveau logique '1'. La transition de l'état cristallin à l'état amorphe est obtenue en appliquant une courte impulsion de courant d'amplitude élevée, pour faire fondre localement le matériau cristallin et le rendre amorphe. La transition de l'état amorphe à l'état cristallin repose également sur un échauffement du matériau, à une température de cristallisation cependant moins élevée. Elle est obtenue en appliquant une impulsion de courant plus longue mais de plus faible amplitude.

Les mémoires PCRAM constituent l'une des technologies les plus prometteuses pour la fabrication des prochaines générations de mémoires non-volatiles réinscriptibles. En effet, elles présentent une forte densité d'intégration et une excellente rétention de l'information. Elles peuvent en outre subir un grand nombre de cycles d'écriture et d'effacement. Toutefois, un inconvénient des structures existantes de mémoires PCRAM réside dans leur consommation électrique élevée.

Pour réduire la consommation d'une cellule de mémoire PCRAM lors de sa programmation, on peut chercher à diminuer la zone d'échauffement du matériau à changement de phase, c'est-à-dire la surface de contact entre le matériau à changement de phase et les électrodes de la cellule. En effet, cette surface de contact, appelée également surface active, influe sur le courant électrique consommé pendant la programmation. La technique la plus courante consiste alors à confiner le matériau à changement de phase dans un volume réduit. On parle dans ce cas d'une mémoire PCRAM « confinée ».

Dans la demande de brevet US2013/0256621 par exemple, le matériau à changement de phase est déposé au-dessus de l'électrode inférieure dans un interstice de dimensions nanométriques.

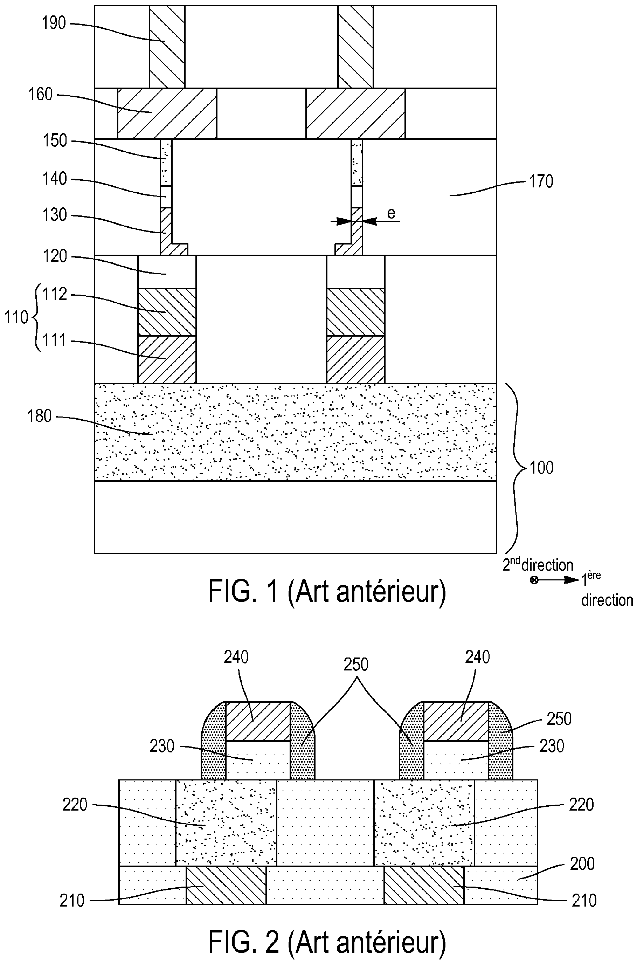

La figure 1 montre en vue de coupe la mémoire PCRAM décrite dans le document US2013/0256621. La mémoire PCRAM comporte classiquement une pluralité de cellules mémoire formées sur un substrat plan 100 en matériau semi-conducteur. Les cellules mémoire sont disposées en rangées et en colonnes sur le substrat 100, sous la forme d'une matrice. Seulement deux cellules d'une rangée sont représentées sur la figure 1.

Chaque cellule mémoire comprend successivement une diode 110 composée d'une zone dopée de type N 111 en contact avec une zone dopée de type P 112, un plot de contact 120 en siliciure métallique, une électrode inférieure 130 en forme de « L », un élément chauffant 140, une couche de matériau à changement de phase 150 et une électrode supérieure 160.

Du côté du substrat 100, la diode 110 de chaque cellule mémoire est connectée à une première piste électriquement conductrice 180 formée dans le substrat. La première piste conductrice 180, qui s'étend dans une première direction parallèlement au plan du substrat 100, connecte les diodes 110 des cellules mémoire appartenant à une même rangée. Elle sert de ligne de mot (ou « word-line » en anglais) pour l'adressage des cellules de la mémoire PCRAM. Du côté opposé au substrat 100, l'électrode supérieure 160 est connectée à une seconde piste électriquement conductrice 190. Cette seconde piste conductrice 190 s'étend parallèlement au substrat 100 dans une seconde direction perpendiculaire à la première direction. La seconde piste conductrice 190 forme une ligne de bit (« bitline »), qui connecte les électrodes supérieures 160 des cellules mémoire appartenant à une même colonne.

Le procédé de fabrication d'une telle structure confinée de mémoire PCRAM comprend la formation d'une tranchée dans une couche de matériau diélectrique 170 déposée sur les plots de contact 120, le dépôt de manière conforme d'une couche de métal au fond et contre les flancs de la tranchée, puis la gravure du métal disposé entre les plots de contact 120 pour délimiter dans la première direction les électrodes inférieures 130 des cellules mémoire. Puis, le métal des électrodes 130 est gravé partiellement pour former des interstices dans la couche diélectrique 170. Le matériau conducteur des éléments chauffants 140 et le matériau à changement de phase 150 sont ensuite déposés dans ces interstices, avant qu'on ne délimite par photolithographie les cellules mémoire dans la seconde direction (i.e. dans la direction normale au plan de la figure 1).

Dans cette configuration de cellule mémoire, les dimensions de la surface active sont donc données par l'épaisseur e de la couche de métal formant les électrodes inférieures 130 et par le pas de photolithographie dans la seconde direction (i.e. l'espace entre deux rangées consécutives de cellules mémoire). La diminution de la surface active se retrouve par conséquent confrontée aux limites de la photolithographie, en termes de dimension critique notamment.

La demande de brevet US2007/0152205 décrit un autre procédé de fabrication de mémoire PCRAM permettant de confiner le matériau à changement de phase et dans lequel la surface active de chaque cellule mémoire n'est pas délimitée par une étape de photolithographie. Cette technique repose sur la formation d'espaceurs en matériau à changement de phase.

La figure 2 est une vue de coupe de deux cellules mémoire formées sur un substrat semi-conducteur 200 grâce à ce procédé de fabrication. Chaque cellule mémoire comprend une électrode inférieure 210 formée dans le substrat 200 et un élément chauffant 220 (appelée dans le document « électrode thermique ») en contact avec l'électrode inférieure 210. En vue de dessus (non représentée), l'élément chauffant 220 a une forme d'anneau. Une couche diélectrique 230 recouvre une partie de cet anneau et une électrode supérieure 240 est déposée sur la couche diélectrique 230. Enfin, deux espaceurs 250 en matériau à changement de phase sont créés de part et d'autre de la couche diélectrique 230 surmontée de l'électrode supérieure 240.

La surface active de la cellule mémoire correspond ici à la superficie de l'élément chauffant 220 en forme d'anneau recouverte par l'un des espaceurs 250 (celui de gauche sur la figue 2). Elle est égale à l'épaisseur de l'anneau multiplié par la largeur du pied de l'espaceur 250.

Ce procédé de fabrication de cellule mémoire PCRAM ne permet pas un contrôle précis de la surface active, et donc du courant de programmation de la cellule, car la forme et les dimensions du pied de l'espaceur 250 sont difficilement contrôlables. En effet, les techniques permettant d'obtenir des espaceurs de petites dimensions ne sont pas totalement maitrisées. Il en résulte que les performances des cellules mémoire varient de façon importante d'une cellule à l'autre.

Il est fait également référence au document US2010190321 qui montre un procédé de fabrication de mémoire PCRAM.

### RESUME DE L'INVENTION

Il existe donc un besoin de prévoir un procédé de fabrication de mémoire à changement de phase (PCRAM) permettant un contrôle précis de la surface active des cellules mémoire, afin de réduire de façon significative leur courant de programmation.

Selon l'invention, on tend à satisfaire ce besoin en prévoyant un procédé de fabrication comprenant les étapes suivantes :
- prévoir un substrat comprenant un ensemble d'électrodes inférieures ;
- former dans une première couche diélectrique disposée sur le substrat une première tranchée rectiligne orientée selon une première direction et débouchant au moins en partie sur l'ensemble d'électrodes inférieures ;
- déposer une première couche active dans la première tranchée rectiligne, de sorte que la première couche active soit disposée en contact électrique avec l'ensemble d'électrodes inférieures ;
- recouvrir la première couche active d'une deuxième couche diélectrique ;
- graver dans la deuxième couche diélectrique, la première couche active et la première couche diélectrique, des tranchées rectilignes additionnelles orientées selon une deuxième direction perpendiculaire à la première direction, de façon à obtenir un groupe de dispositifs mémoire comprenant chacun une portion de la première couche active en contact électrique avec l'une des électrodes inférieures ;
- remplir les tranchées rectilignes additionnelles d'un matériau diélectrique sacrificiel ;
- réaliser une gravure anisotrope du matériau diélectrique sacrificiel de façon à exposer une surface latérale de chaque portion de la première couche active ; et
- recouvrir la surface latérale de chaque portion de la première couche active par une deuxième couche active.

Les première et deuxième couches actives sont constituées de matériaux choisis parmi le matériau à changement de phase et un matériau électriquement conducteur. Autrement dit, l'une des première et deuxième couches actives joue le rôle d'électrode, tandis que l'autre de ces couches, constituée du matériau à changement de phase, remplit la fonction de mémorisation.

On appelle « surface active » la surface de contact entre la première couche active et la deuxième couche active de chaque dispositif ou cellule mémoire. Il s'agit de la plus petite des surfaces de contact entre la couche de matériau à changement de phase et les électrodes. Cette surface de contact limite le courant électrique consommé lors de la programmation de la cellule mémoire : plus elle est faible, moins le courant de programmation est fort.

La gravure d'un matériau est dite anisotrope lorsque la vitesse de gravure varie en fonction de la direction dans laquelle le matériau est gravé. Ainsi, une gravure anisotrope présente une direction préférentielle dans laquelle le matériau est gravé plus rapidement.

Dans ce procédé de fabrication, la surface active est délimitée grâce à l'étape de gravure anisotrope du matériau diélectrique sacrificiel remplissant les tranchées rectilignes additionnelles. La première couche active ayant été « découpée » en plusieurs portions, ou tranches, lors de la réalisation des tranchées rectilignes additionnelles, la gravure anisotrope du matériau diélectrique sacrificiel permet de découvrir une surface latérale de chaque portion de la première couche active, afin d'y déposer la seconde couche active. La surface active est ainsi définie par l'épaisseur de la première couche active (mesurée dans la seconde direction) et par la profondeur de gravure, cette dernière étant fonction des conditions de la gravure, en particulier du temps de gravure et/ou de la direction préférentielle avec laquelle le matériau diélectrique est gravé.

Délimiter la surface active par gravure, plutôt que par photolithographie ou la formation d'espaceurs, permet un contrôle dimensionnel plus précis de cette surface. On parvient ainsi à réduire les disparités de performances entre les différentes cellules de la mémoire. En outre, la première couche active est moins impactée par gravure sur le côté que par une gravure ou un polissage mécano-chimique en face supérieure. Il en résulte un contact électrique de meilleure qualité.

Dans un mode de mise en oeuvre préférentiel, la première couche active est constituée d'un matériau à changement de phase et la deuxième couche active est constituée d'un matériau électriquement conducteur pour former une électrode supérieure. La mémoire PCRAM peut alors être qualifiée de « confinée », car le matériau à changement de phase est contenu dans la première tranchée rectiligne. La surface de contact est dans ce mode de mise en oeuvre limitée par la portion de matériau à changement de phase exposée lors de la gravure anisotrope.

A l'inverse, dans une variante de mise en oeuvre, la première couche active est constituée d'un matériau électriquement conducteur pour former une électrode additionnelle, dite « thermique », et la deuxième couche active est constituée du matériau à changement de phase. La structure correspondante de mémoire PCRAM peut être qualifiée de « planaire », car la couche de matériau à changement de phase est déposée sur la surface exposée de l'électrode thermique. La surface active est alors limitée par l'électrode thermique située dans la première tranchée rectiligne, plutôt que par la couche de matériau à changement de phase.

Dans une autre variante de mise en oeuvre, la première couche active et la deuxième couche active sont constituées d'un matériau à changement de phase et la deuxième couche active est en outre recouverte d'une couche en un matériau électriquement conducteur pour former une électrode supérieure.

La gravure anisotrope du matériau diélectrique sacrificiel peut être réalisée selon une direction préférentielle perpendiculaire au substrat, à travers un masque comprenant une pluralité d'évidements et, dans chaque évidement, des flancs verticaux.

Alternativement, la gravure anisotrope du matériau diélectrique sacrificiel est réalisée selon une direction préférentielle perpendiculaire au substrat, à travers un masque comprenant une pluralité d'évidements et, dans chaque évidement, des flancs obliques.

De préférence, la première couche active est déposée de façon conforme au fond et contre des flancs de la première tranchée rectiligne, l'un des flancs surplombant l'ensemble d'électrodes inférieures. Ainsi, l'épaisseur de la première couche active est faible, alors que les dimensions de la première tranchée sont compatibles avec les techniques usuelles de photolithographie. La surface active de la cellule mémoire s'en trouve fortement réduite. Après un tel dépôt de la première couche active, on procède avantageusement au remplissage de la première tranchée rectiligne par au moins un matériau d'encapsulation électriquement isolant. La deuxième couche diélectrique est alors déposée sur la première couche diélectrique, sur la première couche active et sur le matériau d'encapsulation.

Alternativement, la première couche active est déposée de façon à remplir entièrement la première tranchée rectiligne formée dans la première couche diélectrique. La deuxième couche diélectrique est alors déposée sur la première couche diélectrique et sur la première couche active.

### BREVE DESCRIPTION DES FIGURES

D'autres caractéristiques et avantages de l'invention ressortiront clairement de la description qui en est donnée ci-dessous, à titre indicatif et nullement limitatif, en référence aux figures annexées, parmi lesquelles :
- les figures 1 et 2, précédemment décrites, sont des vues de coupe de mémoires PCRAM fabriquées selon des procédés de l'art antérieur ;
- la figure 3 représente en perspective un substrat de départ sur lequel peut être fabriqué une mémoire PCRAM, d'après un procédé de fabrication selon l'invention ;
- les figures 4A à 4I sont des vues en perspective du substrat au cours des étapes de fabrication de la mémoire PCRAM, d'après un mode de mise en oeuvre préférentiel du procédé selon l'invention ;
- la figure 5 est une vue schématique zoomée du contact établi entre la première couche active et la deuxième couche active, lors de l'étape de la figure 4I ;
- les figures 6G à 6I sont des vues en perspective du substrat, lors d'une variante de mise en oeuvre des étapes correspondant aux figures 4G à 4I ; et
- la figure 7 est une vue schématique zoomée du contact établi entre la première couche active et la deuxième couche active, lors de l'étape de la figure 6I.

Pour plus de clarté, les éléments identiques ou similaires sont repérés par des signes de références identiques sur l'ensemble des figures.

### DESCRIPTION DETAILLEE D'AU MOINS UN MODE DE REALISATION

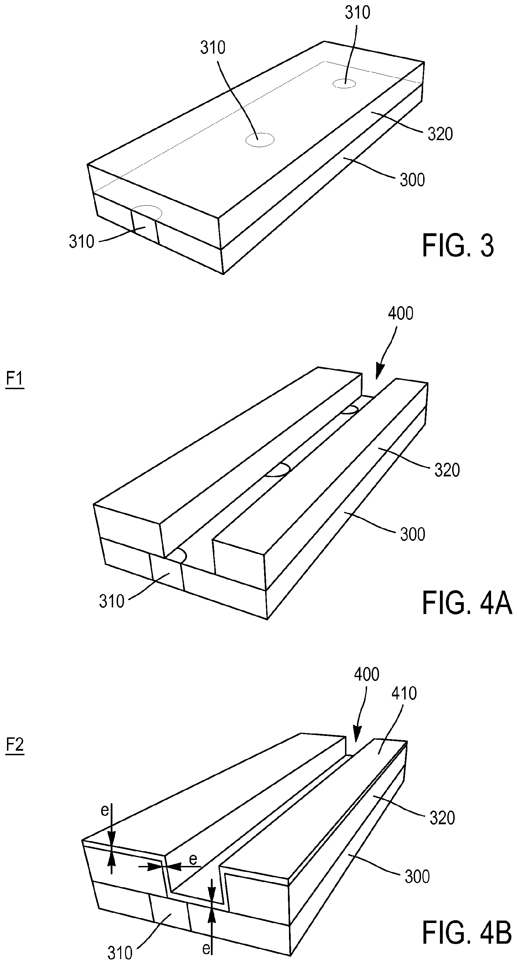

Un mode de mise en oeuvre préférentiel du procédé de fabrication de mémoire PCRAM selon l'invention va maintenant être décrit en référence aux figures 3, 4A à 4I. La figure 3 montre en perspective un substrat plan 300 qui sert de point de départ au procédé de fabrication, tandis que les figures 4A à 4I illustrent des étapes successives F1 à F9 du procédé de fabrication.

Ce procédé vise à former sur le substrat 300 une multitude de cellules mémoire de type PCRAM. Ces cellules mémoire sont, de préférence, disposées en rangées et en colonnes à la surface du substrat 300, sous la forme d'une matrice. Dans un souci de clarté, les figures 3, 4A à 4I ne montrent qu'une partie du substrat 300 correspondant à une colonne de la matrice mémoire.

Le substrat 300 comporte avantageusement un circuit CMOS capable d'adresser chaque cellule mémoire et lire la donnée enregistrée dans la cellule mémoire, soit la valeur de résistance électrique du matériau à changement de phase. Ce circuit comporte par exemple des transistors reliés électriquement aux cellules mémoire par un ou plusieurs niveaux d'interconnexion. Sur la figure 3, on a représenté uniquement le dernier niveau d'interconnexion avant les cellules mémoire. Il est formé d'une couche en matériau diélectrique (par exemple en Si₃N₄, SiO₂ ou Al₂O₃) traversée par des motifs d'interconnexion 310, tels que des via conducteurs ou des pistes conductrices, typiquement en métal (cuivre, aluminium...).

Les motifs d'interconnexion 310, par exemple au nombre de 3 sur la figure 3, constituent les électrodes inférieures des cellules mémoire. Ces électrodes inférieures 310, par exemple en forme de plots cylindriques, sont avantageusement alignées dans une première direction, ici la direction des colonnes de la matrice mémoire. Chaque électrode inférieure 310 appartient à une cellule mémoire de la colonne. La distance entre deux électrodes inférieures 310 consécutives définit ainsi le pas de répétition des cellules mémoire dans la colonne. Elle dépend généralement de l'écart entre les transistors du circuit d'adressage.

Le substrat 300 contenant les électrodes inférieures 310 est recouvert d'une première couche diélectrique 320, par exemple en nitrure de silicium (Si₃N₄). L'épaisseur de la couche diélectrique 320 détermine, dans ce mode de mise en oeuvre préférentiel, la hauteur de la couche active en matériau à changement de phase. Elle est, de préférence, comprise entre 50 nm et 300 nm.

L'étape F1 représentée à la figure 4A consiste à former une première tranchée rectiligne 400 dans la première couche diélectrique 320. La tranchée 400 est orientée dans la première direction et débouche sur les électrodes inférieures 310 de la colonne de cellules mémoire. Une partie au moins de la face supérieure de chaque électrode 310 est exposée après formation de la tranchée 400. La tranchée 400 est par exemple obtenue par une opération de photolithographie, suivie d'une opération de gravure de la première couche diélectrique 320.

Dans ce mode de mise en oeuvre préférentiel du procédé, on souhaite fabriquer une mémoire PCRAM de type confinée. Un des flancs de la tranchée 400 surplombe les électrodes inférieures 310. Ce flanc est destiné à être recouvert d'une fine couche de matériau à changement de phase, appelé ci-après « PCM » (pour « Phase Change Material » en anglais).

Ainsi, à l'étape F2 de la figure 4B, une couche de PCM 410 est déposée au fond et contre des flancs de la tranchée 400. Il s'établit alors un contact entre la couche de PCM 410 et les électrodes inférieures 310 du substrat 300 situées à l'aplomb d'un des deux flancs. De préférence, le dépôt de la couche de PCM 410 est réalisé de manière conforme sur toute la surface du substrat 300 recouvert de la couche diélectrique 320, par exemple par dépôt physique en phase vapeur (PVD), dépôt chimique en phase vapeur (CVD) ou dépôt de couches atomiques (ALD). L'épaisseur e de la couche de PCM 410 est ainsi constante quel que soit l'orientation de la surface sur laquelle elle repose. Cette épaisseur e est, de préférence, comprise entre 2 nm et 20 nm.

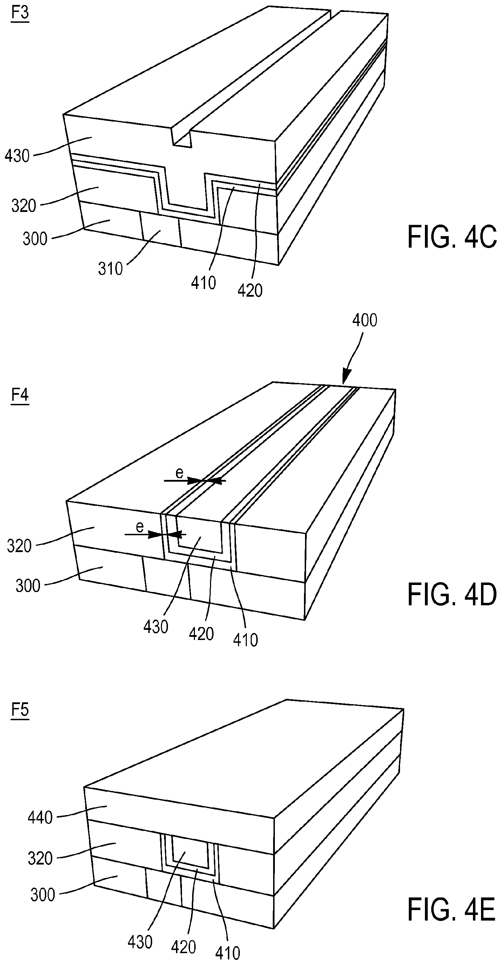

Les étapes F3 à F5, représentées par les figures 4C à 4E respectivement, permettent d'encapsuler le matériau à changement de phase, afin de le protéger de l'oxydation.

A l'étape F3 (Fig.4C), une couche barrière 420 en matériau diélectrique, par exemple en Si₃N₄ ou Ge₃N₄, est déposée sur la couche de PCM 410. Puis, une couche d'aplanissement 430, également en matériau diélectrique (par exemple en SiO₂), est déposée sur la couche barrière 420 de façon à remplir entièrement la tranchée 400. Ces dépôts successifs de matériaux diélectriques sont, de préférence, réalisés de manière conforme, à l'instar du dépôt du matériau à changement de phase. L'épaisseur de la couche barrière 420 est faible comparée à celle de la couche d'aplanissement 430 et à la largeur de la tranchée 400, de préférence comprise entre 20 nm et 50 nm.

La couche barrière 420 bloque la diffusion des atomes d'oxygène vers la couche de PCM 410. Ces atomes d'oxygène peuvent notamment provenir de la couche d'aplanissement 430 en SiO₂. La couche barrière 420 en nitrure peut également servir à isoler thermiquement le matériau à changement de phase.

L'étape F4 comprend une opération de polissage mécano-chimique (CMP) et/ou une opération de gravure afin de retirer les matériaux situés en dehors de la tranchée 400 (Fig.4D). En particulier, les portions des couches 410, 420 et 430 situées au-dessus de la première couche diélectrique 320 sont éliminées. La première couche diélectrique 320 joue avantageusement le rôle de couche d'arrêt lors de l'opération de CMP ou de gravure. On obtient alors, à l'issue de cette étape F4, une surface plane composée de matériaux diélectriques (majoritairement le matériau de la première couche diélectrique 320) et de deux fines lamelles de matériau à changement de phase. Ces deux lamelles de PCM situent les deux flancs de la tranchée rectiligne 400 et ont une largeur égale à l'épaisseur e de la couche de PCM 410. A titre de comparaison, la largeur de la tranchée 400 peut être comprise entre 50 nm et 200 nm.

En F5 (Fig.4E), une deuxième couche diélectrique 440 est déposée sur cette surface plane. La deuxième couche diélectrique 440 recouvre ainsi la première couche diélectrique 320, la couche de PCM 410 (i.e. les deux lamelles), la couche barrière 420 et la couche d'aplanissement 430. Elle est avantageusement constituée d'un nitrure, par exemple Si₃N₄, et son épaisseur peut être comprise entre 10 nm et 30 nm. Le dépôt de la deuxième couche diélectrique 440 finalise l'encapsulation de la couche de PCM 410, qui se trouve dorénavant entièrement entourée de matériaux diélectriques, à l'exception bien sûr des électrodes inférieures 310 situées à la surface du substrat 300. Le matériau à changement de phase est donc totalement protégé de l'oxydation.

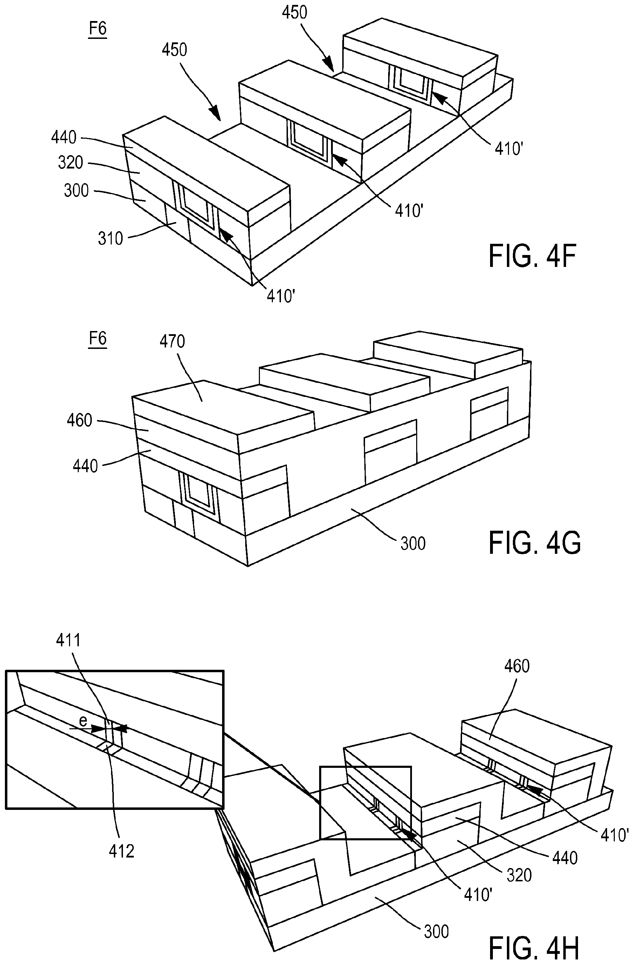

A l'étape F6 de la figure 4F, on forme une pluralité de tranchées additionnelles 450 à travers la seconde couche diélectrique 440 et la première couche diélectrique 320, de préférence jusqu'au substrat 300. Ces secondes tranchées 450, également rectilignes, s'étendent dans une deuxième direction perpendiculaire à la première direction, autrement dit dans la direction des rangées de la matrice mémoire.

A titre d'exemple, les tranchées additionnelles 550 sont obtenues grâce à la réalisation d'un masque dur (non représenté) à la surface de la seconde couche diélectrique 440 et à une opération de gravure anisotrope (par exemple une gravure RIE) à travers le masque dur. La seconde couche diélectrique 440 protège la couche de PCM 410 lors de la réalisation du masque dur, par exemple par photolithographie et gravure. Ainsi, le sommet de la couche de PCM 410 n'est pas affecté lors de la formation des tranchées additionnelles 450.

Par contre, la formation des tranchées additionnelles 450 a pour effet de découper dans le sens de sa longueur la couche de PCM 410 en plusieurs portions ou « tranches » 410' (la gravure anisotrope n'étant pas sélective par rapport au matériau à changement de phase). Chaque tranche 410' de la couche de PCM, en contact électrique avec une électrode inférieure 310, appartient à une cellule mémoire de la colonne et remplit la fonction de mémorisation de cette cellule. Ainsi, la formation des tranchées 450 délimitent les différentes cellules mémoire de la colonne (au nombre de 3 dans l'exemple de la figure 4F), et plus largement les rangées de la matrice mémoire.

En F7 (Fig.4G), un matériau diélectrique sacrificiel 460, par exemple du SiO₂, est déposé sur le substrat 300, de façon à remplir les tranchées additionnelles 450. Ce matériau diélectrique est dit sacrificiel, car il sera ultérieurement gravé afin d'accéder aux tranches 410' de la couche de PCM. Comme illustré sur la figure 4G, le matériau diélectrique sacrificiel 460 peut être déposé de façon à ce qu'il déborde des tranchées 450 sur la seconde couche diélectrique 440, par exemple par CVD. Puis, une étape de polissage mécano-chimique (CMP) est réalisée. Cela permet d'obtenir une couche en matériau diélectrique sacrificiel 460 de surface plane. L'épaisseur de matériau sacrificiel 460 en surplus sur la seconde couche diélectrique 440 peut être comprise entre 50 nm et 100 nm.

Un masque de gravure 470 est ensuite formé à la surface de la couche en matériau diélectrique sacrificiel 460. Le masque de gravure 470 comprend plusieurs évidemment délimitant les zones à graver. Dans ce mode de mise en oeuvre préférentiel, les flancs du masque 470 dans chaque évidemment sont verticaux, c'est-à-dire perpendiculaires au substrat 300. Le masque de gravure 470 peut être un masque dur en SiO₂, obtenu par photolithographie puis gravure, ou formé d'une couche de résine.

A l'étape F8 de la figure 4H, le matériau diélectrique sacrificiel 460 disposé dans les tranchées additionnelles 450 est gravé de façon anisotrope à travers le masque 470, afin de libérer une face latérale de chaque tranche 410'. Puisque située dans les tranchées additionnelles 450, la surface latérale des tranches 410' exposée par la gravure du matériau sacrificiel 460 s'étend dans la deuxième direction sur toute l'épaisseur e de la couche de PCM.

Cette gravure anisotrope est, de préférence, une gravure plasma à base de fluor (ex. CₓF_{y}), sèche et non sélective par rapport au masque 470, par exemple de type RIE. Elle peut être réalisée en présence d'un gaz (ex. Ar, O₂, He) pour rendre le plasma moins réactif, augmentant ainsi l'aspect physique de la gravure. La vitesse de gravure peut être égale à 1 nm/s, même avec une puissance comprise entre 800 W et 1500 W (gamme habituellement utilisée pour la gravure des matériaux diélectriques).

La gravure anisotrope est réalisée, dans l'exemple de la figure 4H, selon une direction préférentielle perpendiculaire au plan du substrat 300. Comme cela est représenté en vue zoomée (cf. l'insert de la figure 4H), la surface exposée de chaque tranche 410' comporte alors une portion verticale 411 (i.e. qui s'étend perpendiculairement au plan du substrat 300), et éventuellement, une portion horizontale 412 (i.e. qui s'étend parallèlement au plan du substrat 300). La largeur des portions 411 et 412, mesurée selon la deuxième direction, est égale à l'épaisseur e de la couche de PCM 410. La longueur de la portion verticale 411, mesurée perpendiculairement au plan du substrat 300, dépend de la profondeur de la gravure anisotrope, c'est-à-dire du temps de gravure (pour une vitesse de gravure donnée).

La présence éventuelle de la portion horizontale 412, ainsi que sa superficie, dépendent de l'alignement du masque de gravure 470 par rapport au bord des tranchées additionnelles 450 de la figure 4F. En effet, lorsque les bords des évidements du masque 470 sont parfaitement alignés sur les bords des tranchées 450, seule la portion verticale 411 des tranches 410' est découverte. Toutefois, dans la mesure où un tel alignement est difficile à réaliser et pour néanmoins garantir un accès au matériau à changement de phase, il est préférable de décaler légèrement les évidements du masque vers l'intérieur des tranches 410'. Une partie de la tranche 410' de PCM est alors gravée, ainsi qu'une partie de la première couche diélectrique 320 et de la deuxième couche diélectrique 440. La valeur du désalignement entre le masque de gravure 470 et les tranchées additionnelles 450 détermine la longueur de la portion horizontale 412.

Le procédé de gravure utilisé peut graver le matériau à changement de phase plus rapidement que les matériaux diélectriques dans la direction préférentielle. Ainsi, la gravure anisotrope du matériau à changement de phase peut se prolonger verticalement jusqu'au substrat 300, auquel cas il n'y aura pas de portion horizontale 412. Ceci n'est pas problématique, puisque la portion verticale 411 constitue une zone préférentielle pour la prise de contact électrique du matériau à changement de phase.

A titre d'exemple, si l'épaisseur e de la couche de matériau à changement de phase 410 est de 5 nm et que la première couche diélectrique 320 est gravée sur 10 nm de profondeur, on obtient une surface active de 50 nm², bien plus petite que dans les procédés de l'art antérieur.

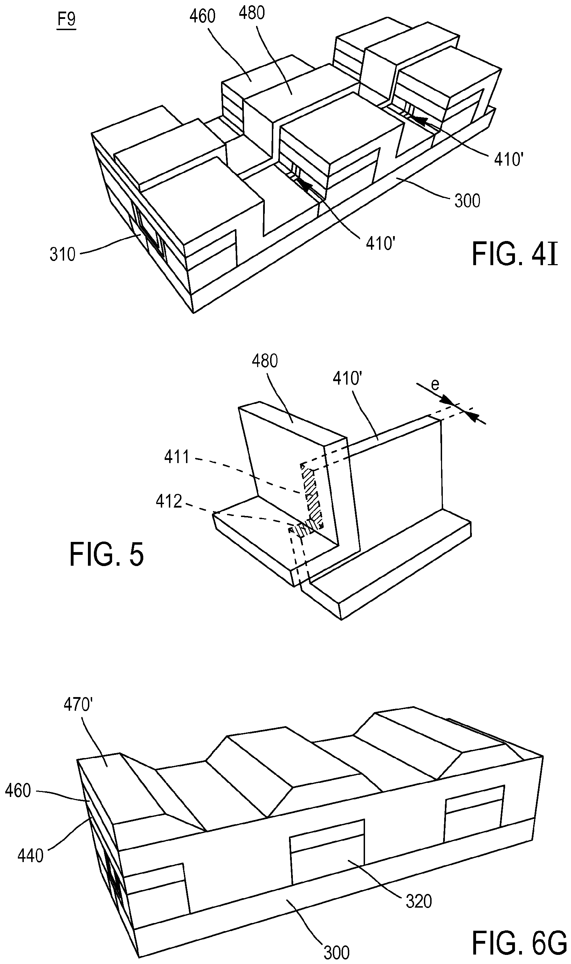

A l'étape F9 de la figure 4I, une électrode supérieure 480 est déposée sur les surfaces exposées des tranches de PCM 410', par exemple par PVD. L'électrode supérieure 480 peut être formée d'une ou plusieurs couches de matériau électriquement conducteur. Des matériaux métalliques, tels que Ti, TiN, Ta et TaN, garantissent un bon contact électrique avec la couche de PCM. Au même titre que l'électrode inférieure 310 et la couche de PCM, l'électrode supérieure 480 constitue une couche électriquement active des cellules mémoire. L'électrode supérieure 480 a, de préférence, la forme d'une piste conductrice qui s'étend de façon continue dans la première direction, en épousant le relief créé par la gravure du matériau sacrificiel 460. Avantageusement, une seule électrode supérieure 480 est utilisée pour connecter les différentes cellules mémoire de la colonne, formant ainsi une ligne de bit pour l'adressage de ces cellules mémoire.

A l'issue de l'étape F9, une dernière couche de matériau diélectrique est avantageusement déposée sur le substrat, de façon à recouvrir entièrement l'électrode supérieure 480 et obtenir une face supérieure plane, puis des contacts électriques débouchant sur l'électrode supérieure 480 sont formés dans la couche diélectrique.

Ainsi, dans le mode de mise en oeuvre préférentiel des figures 4A-4I, la surface active de chaque cellule mémoire correspond à la surface de contact entre la tranche 410' de la couche de PCM et l'électrode supérieure 480. La transition entre les états cristallin et amorphe du matériau à changement de phase s'effectue préférentiellement à cette interface, car la densité de courant y est la plus forte.

La figure 5 est une vue schématique de la surface de contact entre la tranche 410' de la couche de PCM et l'électrode supérieure 480. Comme décrit précédemment, elle comporte une portion verticale 411 correspondant à une face latérale de la tranche 410' de PCM et, le cas échéant, une portion horizontale 412. La surface active est de faibles dimensions grâce au fait qu'on vient réaliser le contact électrique sur la tranche de la couche de PCM 410. L'une des dimensions de la portion latérale 411 est fixe et correspond à l'épaisseur e de la couche de PCM 410. L'autre dimension varie selon la profondeur de la gravure anisotrope.

Les figures 6G à 6I représentent, à partir de l'étape F7 de remplissage des tranchées 450 par le matériau diélectrique sacrificiel 460, une variante de mise en oeuvre du procédé de fabrication.

La figure 6G montre une autre configuration 470' du masque de gravure formé sur la couche de matériau sacrificiel 460. Le masque de gravure 470' possède ici des flancs obliques en vis-à-vis dans chaque évidemment. Un des flancs obliques est disposé à l'aplomb de la surface latérale du matériau à changement en phase que l'on souhaite découvrir. Le masque de gravure 470' aux flancs obliques est avantageusement obtenu grâce à une étape de lithographie par fluage de résine.

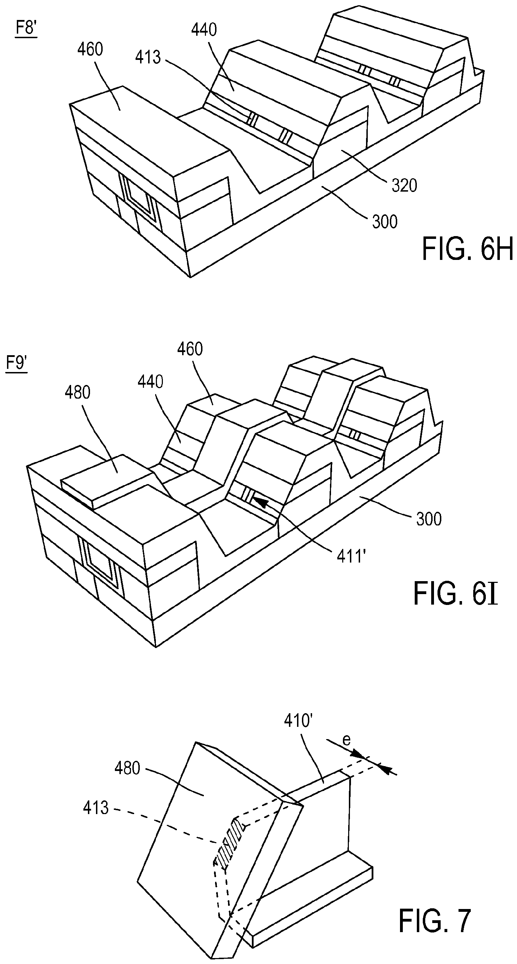

La figure 6H représente une variante F8' de l'étape de gravure anisotrope du matériau sacrificiel 460, permettant de découvrir le matériau à changement de phase. La gravure anisotrope est ici réalisée à travers le masque de gravure 470 aux flancs obliques de la figure 6G. Le procédé de gravure anisotrope peut être identique à celui décrit en relation avec la figure 4H, en conservant notamment le caractère non-sélectif et une direction préférentielle perpendiculaire au substrat. Cela a pour effet de graver non seulement le matériau diélectrique sacrificiel 460 disposé dans les tranchées 450, mais également une partie de la couche de matériau à changement de phase 410 et des couches diélectriques 320 et 440. Ces couches présentent toutes un flanc oblique après la gravure anisotrope, car l'empreinte du masque 470 est transférée dans le substrat. Une surface latérale oblique 413 de la tranche 410' de PCM est ainsi exposée. La surface latérale 413 est, de préférence, inclinée par rapport à la normale au substrat d'un angle compris entre 25° et 65°.

L'avantage de cette solution est que la surface latérale 413 du matériau à changement de phase est ainsi exposée moins longtemps à la chimie de gravure, comparativement au mode de mise en oeuvre de la figure 4H dans lequel la surface du matériau à changement de phase (portion verticale 411) est exposée pendant tout la durée de la gravure (dès lors qu'on commence à graver la couche diélectrique 320). En outre, le profil en pente créé par la gravure anisotrope à travers le masque aux flancs obliques favorise la reprise de contact sur la surface active, notamment pendant le dépôt de l'électrode supérieure 480.

Ainsi, l'étape F9' représentée par la figure 6I est une variante de l'étape de dépôt de l'électrode supérieure 480 sur le matériau à changement de phase. L'électrode supérieure 480 est déposée sur le flanc oblique de la tranche 410' de PCM, par exemple de la même façon qu'indiquée précédemment en relation avec la figure 5I.

Comme cela est visible en gros plan sur la figure 7, la surface active latérale est dans ce cas constituée d'une seule face oblique 413. L'une des dimensions de la face oblique 413 est fixe et correspond à l'épaisseur e de la couche de PCM 410. L'autre dimension est variable selon la profondeur de la gravure anisotrope et l'angle d'inclinaison de la gravure anisotrope, c'est-à-dire l'angle formée entre la direction préférentielle de la gravure et la normale au substrat.

Dans une variante de mise en oeuvre du procédé de fabrication (non représentée sur les figures), la couche de PCM 410 peut occuper tout le volume de la première tranchée rectiligne 400, plutôt que d'être limitée au fond et aux flancs de la tranchée comme cela est illustré sur la figure 4B. Cela simplifie grandement l'étape d'encapsulation du matériau à changement de phase, car il suffit alors de déposer la deuxième couche diélectrique 440 sur la première couche diélectrique 320 et sur la couche de PCM 410 (cf. Fig.4E). La surface active est par contre agrandie, car l'épaisseur e de la couche de PCM 410 est plus importante (cf. Fig.5). Par conséquent, le courant de programmation des cellules mémoire sera plus élevé dans cette variante de mise en oeuvre que dans le mode de mise en oeuvre des figures 4A-4I et 5.

Dans toutes les structures de mémoire PCRAM décrites jusqu'à présent, la première couche active 410 déposée dans la première tranchée rectiligne 400 est constituée d'un matériau à changement de phase et la seconde couche active 470, déposée sur la première couche active, constitue l'électrode supérieure. Le matériau à changement de phase de chaque cellule mémoire est ainsi confiné dans la tranchée 400 et isolé de celui des cellules adjacentes par du matériau diélectrique, ce qui pour effet de réduire davantage le courant de programmation (car la dissipation thermique est ralentie). Ces structures de mémoire PCRAM sont toutes appelées « confinées » en raison du confinement du matériau à changement de phase dans la tranchée 400.

Le procédé de fabrication selon l'invention n'est toutefois pas limité à la réalisation de structures de mémoire PCRAM confinées. En effet, le même enchaînement d'étapes peut être utilisé pour la fabrication de mémoires PCRAM ayant une structure planaire.

Pour fabriquer une mémoire PCRAM de structure planaire, on peut notamment inverser la nature des matériaux formant la première couche active 410 et la seconde couche active 470. On dépose ainsi dans la première tranchée rectiligne 400 un matériau électriquement conducteur, par exemple TiN, W, WSi ou TaN, afin de former une électrode thermique 410 par-dessus l'électrode inférieure 310. Cette électrode est destinée à conduire le courant électrique jusqu'au matériau à changement de phase et à chauffer localement ce matériau par effet Joule. Sa résistivité électrique est avantageusement supérieure à celles des électrodes inférieures 310 en cuivre ou en aluminium. La couche de PCM 470 est déposée sur la surface exposée de l'électrode thermique 410 après gravure anisotrope du matériau diélectrique sacrificiel, comme cela a été décrit en relation avec les figures 4H-4I ou 5H-51. Puis, cette couche de PCM 470 est recouverte par une électrode supérieure. L'électrode supérieure peut avoir la même forme que la couche à changement de phase 470, par exemple une bande continue s'étendant dans la première direction sur plusieurs cellules mémoire de la colonne. La couche de matériau à changement de phase et l'électrode supérieure peuvent d'ailleurs être délimitées lors de la même étape de photolithographie.

Une autre structure, à mi-chemin entre les structures « confinée » et « planaire », peut être obtenue en suivant le procédé de fabrication des figures 4A-4I (ou 4A-4F, puis 6G-6I), mais en remplaçant à l'étape F9 de la figure 4I (ou F9', Fig.6I) l'électrode supérieure 480 par un empilement bicouche constitué d'une couche additionnelle de PCM et d'une couche en matériau conducteur servant d'électrode supérieure. On obtient ainsi une première couche de PCM 410 (disposée contre les parois de la première tranchée rectiligne 400) en contact avec une deuxième couche de PCM sur une très faible surface. Cette structure permet d'obtenir un confinement thermique de la surface active, car les matériaux à changement sont d'excellents isolants thermiques. Grâce à ce confinement thermique, le courant de programmation de la cellule mémoire est davantage réduit. En effet, la cellule mémoire demandera moins d'énergie pour atteindre les températures de cristallisation et de fusion du matériau à changement du fait que la dissipation thermique est faible.

Naturellement, le procédé de fabrication décrit ci-dessus s'étend à l'ensemble du substrat 300, car toutes les cellules de la matrice mémoire sont fabriquées simultanément. Pour chaque colonne de la matrice, on formera une tranchée rectiligne 400 comme décrit en relation avec la figure 4A. Les tranchées 400 correspondant aux différentes colonnes seront disposées en parallèle les unes des autres.

D'autres configurations d'électrodes inférieures et supérieures que celles décrites précédemment peuvent être envisagées. Par exemple, les électrodes inférieures 310 des cellules mémoire peuvent avoir la forme d'une piste conductrice s'étendant dans la seconde direction, formant une ligne de mot qui connecte toutes les cellules mémoire appartenant à une même rangée.

## Revendications

1. Procédé de fabrication d'une mémoire PCRAM comprenant les étapes suivantes :
- prévoir un substrat (300) comprenant un ensemble d'électrodes inférieures (310) ;
- former (F1) dans une première couche diélectrique (320) disposée sur le substrat (300) une première tranchée rectiligne (400) orientée selon une première direction et débouchant au moins en partie sur l'ensemble d'électrodes inférieures (310) ;
- déposer (F2) une première couche active (410) dans la première tranchée rectiligne (400), de sorte que la première couche active soit disposée en contact électrique avec l'ensemble d'électrodes inférieures (310) ;
- recouvrir (F5) la première couche active (410) d'une deuxième couche diélectrique (440) ;
- graver (F6) dans la deuxième couche diélectrique (440), la première couche active (410) et la première couche diélectrique (320), des tranchées rectilignes additionnelles (450) orientées selon une deuxième direction perpendiculaire à la première direction, de façon à obtenir un groupe de dispositifs mémoire comprenant chacun une portion (410') de la première couche active (410) en contact électrique avec l'une des électrodes inférieures (310) ;
- remplir (F7) les tranchées rectilignes additionnelles (450) d'un matériau diélectrique sacrificiel (460) ;
**caractérisé en ce qu'**il comporte les étapes suivantes :
- réaliser (F8, F8') une gravure anisotrope du matériau diélectrique sacrificiel (460) de façon à exposer une surface latérale (411, 413) de chaque portion (410') de la première couche active ; et
- recouvrir (F9, F9') la surface latérale (411, 413) de chaque portion (410') de la première couche active par une deuxième couche active (480).

2. Procédé selon la revendication 1, dans lequel la première couche active (410) est constituée d'un matériau à changement de phase et dans lequel la deuxième couche active (480) est constituée d'un matériau électriquement conducteur pour former une électrode supérieure.

3. Procédé selon la revendication 1, dans lequel la première couche active (410) est constituée d'un matériau électriquement conducteur pour former une électrode thermique et dans lequel la deuxième couche active (480) est constituée d'un matériau à changement de phase.

4. Procédé selon la revendication 1, dans lequel la première couche active (410) et la deuxième couche active (480) sont constituées d'un matériau à changement de phase et dans lequel la deuxième couche active (480) est en outre recouverte d'une couche en un matériau électriquement conducteur pour former une électrode supérieure.

5. Procédé selon l'une quelconque des revendications 1 à 4, dans lequel la gravure anisotrope (F8) du matériau diélectrique sacrificiel (460) est réalisée selon une direction préférentielle perpendiculaire au substrat (300), à travers un masque (470) comprenant une pluralité d'évidements et, dans chaque évidement, des flancs verticaux.

6. Procédé selon l'une quelconque des revendications 1 à 4, dans lequel la gravure anisotrope (F8') du matériau diélectrique sacrificiel (460) est réalisée selon une direction préférentielle perpendiculaire au substrat (300), à travers un masque (470') comprenant une pluralité d'évidements et, dans chaque évidement, des flancs obliques.

7. Procédé selon l'une quelconque des revendications 1 à 6, dans lequel la première couche active (410) est déposée (F2) de façon conforme au fond et contre des flancs de la première tranchée rectiligne (400), l'un des flancs surplombant l'ensemble d'électrodes inférieures (310).

8. Procédé selon la revendication 7, comprenant en outre une étape (F3-F4) de remplissage de la première tranchée rectiligne (400) par au moins un matériau d'encapsulation électriquement isolant (420, 430), la deuxième couche diélectrique (440) étant déposée sur la première couche diélectrique (320), sur la première couche active (410) et sur le matériau d'encapsulation (420, 430).

9. Procédé selon l'une quelconque des revendications 1 à 6, la première couche active (410) est déposée de façon à remplir entièrement la première tranchée rectiligne (400), la deuxième couche diélectrique (440) étant déposée sur la première couche diélectrique (320) et sur la première couche active (410).

## Patentansprüche

1. Herstellungsverfahren eines PCRAM-Speichers, umfassend die folgenden Schritte:
- Vorsehen eines Substrats (300), umfassend eine Gruppe von unteren Elektroden (310);
- Bilden (F1) eines ersten geradlinigen Grabens (400), der gemäß einer ersten Richtung ausgerichtet ist und wenigstens zum Teil auf der Gruppe von unteren Elektroden (310) mündet, in einer ersten dielektrischen Schicht (320), die auf dem Substrat (300) angeordnet ist;
- Aufbringen (F2) einer ersten aktiven Schicht (410) in dem ersten geradlinigen Graben (400) derart, dass die erste aktive Schicht in elektrischem Kontakt mit der Gruppe von unteren Elektroden (310) angeordnet ist;
- Abdecken (F5) der ersten aktiven Schicht (410) mit einer zweiten dielektrischen Schicht (440);
- Ätzen (F6) von zusätzlichen geradlinigen Gräben (450), die gemäß einer zweiten, zur ersten Richtung lotrechten Richtung ausgerichtet sind, in der zweiten dielektrischen Schicht (440), der ersten aktiven Schicht (410) und der ersten dielektrischen Schicht (320), derart, dass eine Gruppe von Speichervorrichtungen erhalten wird, die jeweils einen Abschnitt (410') der ersten aktiven Schicht (410) in elektrischem Kontakt mit einer der unteren Elektroden (310) umfasst;
- Befüllen (F7) der zusätzlichen, geradlinigen Gräben (450) eines dielektrischen Opfermaterials (460);
**dadurch gekennzeichnet, dass** es die folgenden Schritte umfasst:
- Realisieren (F8, F8') einer anisotropen Gravur des dielektrischen Opfermaterials (460) derart, dass eine laterale Oberfläche (411, 413) jedes Abschnitts (410') der ersten aktiven Schicht freigelegt wird; und
- Abdecken (F9, F9') der lateralen Oberfläche (411, 413) jedes Abschnitts (410') der ersten aktiven Schicht durch eine zweite aktive Schicht (480).

2. Verfahren gemäß Anspruch 1, bei dem die erste aktive Schicht (410) aus einem Material zur Phasenveränderung gebildet ist und in dem die zweite aktive Schicht (480) aus einem elektrisch leitenden Material gebildet ist, um eine obere Elektrode zu formen.

3. Verfahren gemäß Anspruch 1, bei dem die erste aktive Schicht (410) aus einem elektrisch leitenden Material gebildet ist, um eine thermische Elektrode zu formen, in der die zweite aktive Schicht (480) aus einem Material zur Phasenveränderung gebildet ist.

4. Verfahren gemäß Anspruch 1, bei dem die erste aktive Schicht (410) und die zweite aktive Schicht (480) aus einem Material zur Phasenveränderung gebildet sind und bei dem die zweite aktive Schicht (480) darüber hinaus mit einer Schicht aus einem elektrisch leitenden Material abgedeckt ist, um eine obere Elektrode zu formen.

5. Verfahren gemäß irgendeinem der Ansprüche 1 bis 4, bei dem die anisotrope Gravur (F8) des dielektrischen Opfermaterials (460) gemäß einer bevorzugten, zum Substrat (300) lotrechten Richtung durch ein Maske (470) realisiert ist, die eine Vielzahl von Ausnehmungen und in jeder Ausnehmung vertikale Flanken umfasst.

6. Verfahren gemäß irgendeinem der Ansprüche 1 bis 4, bei dem die anisotrope Gravur (F8') des dielektrischen Opfermaterials (460) gemäß einer bevorzugten, zum Substrat (300) lotrechten Richtung durch eine Maske (470') realisiert ist, die eine Vielzahl von Ausnehmungen und in jeder Ausnehmung schräge Flanken umfasst.

7. Verfahren gemäß irgendeinem der Ansprüche 1 bis 6, bei dem die erste aktive Schicht (410) konform zu dem Boden und gegen die Flanken des ersten geradlinigen Grabens (400) aufgebracht ist, wobei eine der Flanken die Gruppe von unteren Elektroden (310) überragt.

8. Verfahren gemäß Anspruch 7, darüber hinaus umfassend einen Schritt (F3-F4) zum Befüllen des ersten geradlinigen Grabens (400) durch wenigstens ein elektrisch isolierendes Verkapselungsmaterial (420, 430), wobei die zweite dielektrische Schicht (440) auf der ersten dielektrischen Schicht (320), auf der ersten aktiven Schicht (410) und auf dem Verkapselungsmaterial (420, 430) aufgebracht ist.

9. Verfahren gemäß irgendeinem der Ansprüche 1 bis 6, wobei die erste aktive Schicht (410) derart aufgebracht ist, dass der erste geradlinige Graben (400) vollständig befüllt wird, wobei die zweite dielektrische Schicht (440) auf der ersten dielektrischen Schicht (320) und auf der ersten aktiven Schicht (410) aufgebracht ist.

## Claims

1. Method for manufacturing a PCRAM memory comprising the following steps:
- providing a substrate (300) comprising a set of bottom electrodes (310);
- forming (F1) in a first dielectric layer (320) arranged on the substrate (300) a first rectilinear trench (400) oriented in a first direction, and opening at least partially on to the set of bottom electrodes (310);
- depositing (F2) a first active layer (410) in the first rectilinear trench (400), such that the first active layer is brought in electrical contact with the set of bottom electrodes (310);
- covering (F5) the first active layer (410) with a second dielectric layer (440);
- etching (F6), in the second dielectric layer (440), the first active layer (410) and the first dielectric layer (320), additional rectilinear trenches (450) oriented in a second direction perpendicular to the first direction, so as to obtain a group of memory devices each comprising a portion (410') of the first active layer (410) in electrical contact with one of the bottom electrodes (310);
- filling (F7) the additional rectilinear trenches (450) with a sacrificial dielectric material (460);
**characterised in that** it comprises the following steps:
- performing (F8, F8') an anisotropic etching of the sacrificial dielectric material (460) so as to expose a side surface (411, 413) of each portion (410') of the first active layer; and
- covering (F9, F9') the side surface (411, 413) of each portion (410') of the first active layer with a second active layer (480).

2. Method according to claim 1, wherein the first active layer (410) is comprised of a phase change material and wherein the second active layer (480) is comprised of an electrically conductive material to form a top electrode.

3. Method according to claim 1, wherein the first active layer (410) is comprised of an electrically conductive material to form a thermal electrode and wherein the second active layer (480) is comprised of a phase change material.

4. Method according to claim 1, wherein the first active layer (410) and the second active layer (480) are comprised of a phase change material and wherein the second active layer (480) is further covered with a layer of an electrically conductive material to form a top electrode.

5. Method according to any of claims 1 to 4, wherein the anisotropic etching (F8) of the sacrificial dielectric material (460) is accomplished in a preferential direction perpendicular to the substrate (300), through a mask (470) comprising a plurality of recesses and, in each recess, vertical sides.

6. Method according to any of claims 1 to 4, wherein the anisotropic etching (F8') of the sacrificial dielectric material (460) is accomplished in a preferential direction perpendicular to the substrate (300), through a mask (470') comprising a plurality of recesses and, in each recess, oblique sides.

7. Method according to any of claims 1 to 6, wherein the first active layer (410) is deposited (F2) in a conforming manner on the bottom and against the sides of the first rectilinear trench (400), where one of the sides overhangs the set of bottom electrodes (310).

8. Method according to claim 7, further comprising a step (F3-F4) of filling the first rectilinear trench (400) with at least one electrically insulating encapsulation material (420, 430), the second dielectric layer (440) being deposited on the first dielectric layer (320), on the first active layer (410) and on the encapsulation material (420, 430).

9. Method according to any of claims 1 to 6, the first active layer (410) is deposited so as to fill completely the first rectilinear trench (400), the second dielectric layer (440) being deposited on the first dielectric layer (320) and on the first active layer (410).
